(19) Europäisches Patentamt
European Patent Office
Office européen des brevets

(11) **EP 3 304 107 B1**

(12) **FASCICULE DE BREVET EUROPEEN**

(45) Date de publication et mention
de la délivrance du brevet:
**10.04.2019  Bulletin 2019/15**

(21) Numéro de dépôt: **16726807.7**

(22) Date de dépôt: **17.05.2016**

(51) Int Cl.:
*G01R 31/11* (2006.01)      *H04B 3/46* (2015.01)

(86) Numéro de dépôt international:
**PCT/EP2016/061004**

(87) Numéro de publication internationale:
**WO 2016/192980 (08.12.2016 Gazette 2016/49)**

(54) **PROCEDE ET DISPOSITIF DE REFLECTOMETRIE POUR LE DIAGNOSTIC DE CABLES EN FONCTIONNEMENT**

REFLEKTOMETRIEVERFAHREN UND VORRICHTUNG ZUR DIAGNOSE VON KABELN IM EINSATZ

REFLECTOMETRY METHOD AND DEVICE FOR DIAGNOSING CABLES IN USE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **04.06.2015  FR 1555080**

(43) Date de publication de la demande:
**11.04.2018  Bulletin 2018/15**

(73) Titulaire: **WIN MS**
**91400 Orsay (FR)**

(72) Inventeur: **SOMMERVOGEL, Laurent**
**78350 Jouy-En-Josas (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**FR-A1- 2 931 323**

• **Adrien Lelong: "Méthodes de diagnostic filaire embarqué pour des réseaux complexes", , 9 décembre 2010 (2010-12-09), pages 1-167, XP055047458, agence bibliographique de l'enseignement supérieur Extrait de l'Internet: URL:http://www.theses.fr/2010LIL10121 [extrait le 2012-12-11]**
• **WAFA BEN HASSEN ET AL: "On-line diagnosis using Orthogonal Multi-Tone Time Domain Reflectometry in a lossy cable", SYSTEMS, SIGNALS&DEVICES (SSD), 2013 10TH INTERNATIONAL MULTI-CONFERENCE ON, IEEE, 18 mars 2013 (2013-03-18), pages 1-6, XP032439823, DOI: 10.1109/SSD.2013.6564144 ISBN: 978-1-4673-6459-1**

EP 3 304 107 B1

**Description**

La présente invention concerne un procédé et un dispositif de réflectométrie, notamment de type multiporteuse, pour le diagnostic de câbles en fonctionnement.

Le diagnostic d'une ligne ou d'un câble électrique par réflectométrie est une méthode bien connue consistant en l'injection d'un signal large bande dans la ligne et en la détection des échos, afin de tracer les variations d'impédance caractéristique de la ligne correspondant à des singularités, notamment des défauts tels que par exemple des circuits ouverts ou des courts-circuits.

Dans sa version la plus simple, le signal de sonde est une impulsion dont la durée dépend de la bande passante et de la longueur du câble à diagnostiquer.

Parmi les méthodes de réflectométrie connues, la méthode de réflectométrie multiporteuse dite MCTDR (« Multi Carrier Time Domain Reflectometry ») présente l'avantage de pouvoir contrôler précisément le spectre du signal injecté et de pouvoir ainsi répondre à des contraintes de compatibilité électromagnétique (CEM) imposées.

Par la suite, les conventions suivantes seront adoptées :

- \* désigne le produit de convolution
- ★ désigne la corrélation croisée (inter corrélation)
- $h$ désigne la réponse impulsionnelle du câble
- $\hat{h}$ désigne la réponse estimée du câble : le réflectogramme
- $x$ désigne le signal injecté
- $y$ désigne le signal réfléchi
- Les notations en majuscules désignent les transformées de Fourier de celles en minuscules
- $F\{ \}$ désigne l'opération de transformation de Fourier
- $F^{-1}\{ \}$ désigne l'opération de transformation de Fourier inverse.

Les signaux injecté $x$ et réfléchi $y$ sont liés par l'équation suivante : $y = x*h$.

Une mesure de réflectométrie a notamment pour but de mesurer le signal $h$, si possible avec un maximum de précision. $h$ peut être considéré comme un signal parcimonieux, c'est-à-dire qu'il contient uniquement des pics à l'emplacement des singularités sur le câble. Dans un cas simplifié idéal pour un câble dont l'extrémité est en circuit ouvert, la différence de position entre les deux premiers pics de $h$ permet de remonter à la connaissance de la longueur du câble.

Lorsque l'on souhaite surveiller ou diagnostiquer un câble en fonctionnement, il est nécessaire de procéder à une mesure non invasive, à défaut d'être non intrusive. Deux conditions doivent alors être respectées :

- Il faut trouver un moyen de couplage adéquat, notamment en termes d'impédance ;
- Il ne faut pas injecter des signaux ayant des composantes fréquentielles chevauchant des bandes de fréquences déjà utilisées dans l'application cible. En d'autres termes, il faut éviter toute interférence entre les signaux liés au fonctionnement de l'application cible et les signaux liés à la réflectométrie, cela se traduisant par diverses contraintes au niveau CEM, occupation spectrale et robustesse au bruit.

La deuxième condition permet notamment d'obtenir la double garantie suivante :

- Les signaux de diagnostic n'interfèrent pas avec ceux de l'application en fonctionnement, en émission ;
- Les signaux de l'application ne dégradent pas la qualité du diagnostic, en termes de susceptibilité.

A titre d'exemple :

- Pour le diagnostic d'un câble d'antenne pour l'application d'une réception radio FM, la bande de fréquence 88-108 MHz doit être évitée pour le signal de diagnostic ;
- Pour le diagnostic du bus CAN d'un véhicule, la bande 0,1-2 MHz doit de même être évitée.

La technique MCTDR, notamment décrite dans la demande de brevet FR 2 931 323 A1 permet de construire un signal de sonde répondant à un gabarit spectral donné. La solution décrite peut gérer un nombre quelconque de bandes de fréquences avec un coefficient d'atténuation variable dans chaque bande, pouvant aller jusqu'à l'extinction totale.

Cependant dans la solution décrite, il faut faire face à une limitation technique importante. En effet, plus on atténue ou plus on supprime de bandes de fréquences, plus on diminue la richesse du contenu fréquentiel sur la mesure du signal réfléchi y, et plus on dégrade la qualité du diagnostic. En particulier, si on considérait une impulsion idéale, représentée par un Dirac $x = \delta$, pour diagnostiquer le câble, on obtiendrait $h = y$. Cependant, la MCTDR est une technique de compression d'impulsion. C'est-à-dire que l'énergie n'est pas concentrée sur un temps très court mais répartie sur toute la durée du signal. On peut montrer mathématiquement dans ce cas que : $\hat{h} = R_{xx} * h$, avec $R_{xx} = x \star x$, cette auto corrélation étant appelée le motif. Le cas idéal $R_{xx} = \delta$ n'est possible que si x contient toutes les fréquences. Or, plus on enlève des composantes fréquentielles, moins le motif ressemble à une impulsion.

Il existe plusieurs techniques permettant un diagnostic sans interférer avec une application cible.

La réflectométrie SSTDR (« Spread Spectrum Time Domain Reflectometry ») est une variante de la réflectométrie STDR (« Sequence Time Domain Reflectometry »). La STDR est aussi une technique de compression d'impulsions. Avec cette technique, au lieu d'injecter une impulsion, on injecte dans le câble une séquence binaire de créneaux, composées de +1 et de -1, en faisant en sorte que l'auto corrélation de la séquence soit proche d'une impulsion.

La STDR ne permet pas de s'affranchir des contraintes CEM mais la SSTDR y apporte une réponse. A cet effet, on module la séquence STDR par une porteuse sinusoïdale de fréquence $f_0$. C'est donc en fait une séquence STDR modulée. Pour répondre aux contraintes opérationnelles, on choisit $f_0$ de façon à éloigner le signal modulé des bandes interdites.

Une méthode de réflectométrie décrite dans le document FR 2 931 323 A1 est une méthode itérative visant à remonter à $h$ à partir de la réponse impulsionnelle estimée $\hat{h}$. C'est un algorithme de post-traitement qui peut prendre en entrée une mesure de réflectométrie faite avec un signal sonde de type MCTDR. Il hérite donc de son innocuité du point de vue CEM.

La réflectométrie multiporteuse, dite MCR (Multi Carrier Reflectometry), utilise les mêmes formes d'onde que la MCTDR, avec une somme pondérée de sinusoïdes. Pour cette raison, elle apporte la même qualité de réponse aux problèmes de CEM.

Le traitement du signal réfléchi est cependant très différent, puisqu'il s'agit d'un algorithme d'optimisation (type moindres carrés) directement appliqué dans le domaine fréquentiel afin d'adapter les coefficients ($\alpha$; $\tau$) d'un modèle de réponse impulsionnelle parcimonieux simplifié pour le câble :

$$\hat{h}(t) = \sum_i \alpha_i \delta(t - 2i\tau)$$

Ce traitement présente l'avantage de pouvoir être effectué pour un nombre limité de fréquences d'excitation.

La technique MCR est notamment décrite dans l'article « Multicarrier Reflectometry », IEEE SENSORS JOURNAL, VOL. 6, No. 3, Juin 2006.

Un problème à résoudre est notamment de permettre la flexibilité des méthodes d'injection à gabarit spectral contrôlé, comme la MCTDR notamment, tout en s'affranchissant des problèmes de dénaturation du motif qui introduisent un biais dans le résultat du diagnostic.

Les méthodes de réflectométrie décrites précédemment ne résolvent pas ce problème ou le résolvent insuffisamment.

La réflectométrie SSTDR semble répondre à ce problème, mais elle présente cependant plusieurs inconvénients :

- Le système de modulation autour de la fréquence $f_0$ introduit une complexité de réalisation et des coûts supplémentaires.

- Il est compliqué de changer $f_0$ « à la volée », ce qui ne permet pas une reconfiguration dynamique du système de diagnostic.

- Dans certaines applications, il peut même être compliqué de trouver une fréquence $f_0$ disponible, il est à noter que l'on reste limité par la bande passante du câble et $f_0$ ne peut être choisie arbitrairement haute.

De même, l'algorithme décrit dans le document FR 2 931 323 A1 en tant que post-traitement pourrait convenir. Cependant sa robustesse est mise en cause lorsque des pics se trouvent trop proches les uns des autres dans la réponse impulsionnelle $h$ du câble. Par ailleurs, il commence à converger de façon erronée lorsqu'environ plus d'un sixième (1/6) de bande utile du signal de test a été supprimé.

De son côté, bien que la méthode MCR semble insensible à l'annulation de ses coefficients, elle souffre notamment des défauts rédhibitoires suivants :

- Son utilisation est restreinte à des câbles point-à-point.

- Elle entraîne une imprécision de localisation qui peut atteindre 3% à 5% de la longueur d'un câble.

Un but de l'invention est notamment de pallier les inconvénients précités. A cet effet, l'invention a pour objet un procédé de diagnostic d'au moins une ligne électrique par des mesures de réflectométrie, ladite ligne électrique étant en fonctionnement dans une bande de fréquences donnée, le diagnostic étant effectué par analyse du réflectogramme de ladite ligne, ledit procédé comportant notamment les étapes suivantes :

-   On paramètre le signal à injecter dans ladite ligne, un signal d'injection complet ayant un spectre numérique formé de composantes pondérées par un jeu de coefficients, dans une étape préliminaire on atténue les coefficients des composantes comprises dans ladite bande de fréquence conduisant à l'obtention un spectre numérique incomplet.
-   Dans une étape suivante on injecte dans la ligne électrique (10) le signal analogique constitué à partir dudit spectre numérique incomplet.
-   Dans une étape suivante on récupère l'écho correspondant audit signal injecté par échantillonnage de mesures dudit écho.
-   Dans une étape suivante, on calcule le spectre numérique ($Y_{cancel}$) dudit écho.
-   Dans une étape suivante on estime le spectre numérique ($\hat{Y}_{full}$) de l'écho du signal analogique complet si celui-ci avait été injecté, la k$^{\text{ième}}$ composante ($\hat{Y}_{fullk}$) du spectre numérique complet estimé étant égale à la k$^{\text{ième}}$ composante ($Y_{cancelk}$) du spectre numérique de l'écho reçu multiplié par le rapport ($\xi_k$) entre la k$^{\text{ième}}$ composante ($X_{fullk}$) du spectre numérique du signal d'injection complet sur la k$^{\text{ième}}$ composante ($X_{cancelk}$) du spectre numérique incomplet.
-   Dans une étape suivante, on obtient la mesure du réflectogramme de ladite ligne à partir du spectre numérique complet estimé ($\hat{Y}_{full}$).

Le signal injecté étant calculé sur N points, l'écho est par exemple échantillonné sur NP points de mesure, le spectre numérique ($Y_{cancel}$) de l'écho étant calculé sur lesdits NP points échantillonnés, P étant strictement supérieur à 2, P pouvant être supérieur ou égal à 10.

Les rapports ($\xi_k$) sont par exemple calculés sur N points, les N rapports calculé étant repris P fois.

Dans le cas où le signal injecté n'est pas du type MCTDR, ledit rapport est par exemple défini selon la relation suivante :

$$\xi = \lim_{\varepsilon \to 0} \frac{X_{\text{full}} X_{\text{cancel}}^*}{\left| X_{\text{cancel}} \right|^2 + \varepsilon}$$

$X_{full}$ et $X_{cancel}$ étant respectivement le spectre numérique du signal d'injection complet et le spectre numérique du signal injecté.

L'invention a également pour objet un dispositif de réflectométrie, apte à être utilisé pour le diagnostic d'une ligne en fonctionnement dans une bande de fréquences donnée, ledit dispositif comportant au moins :

-   un bloc de paramétrage pour paramétrer le signal à injecter dans ladite ligne, un signal d'injection complet ayant un spectre numérique formé de composantes pondérées par un jeu de coefficients, les coefficients des composantes comprises dans ladite bande de fréquence étant atténués pour obtenir un spectre numérique incomplet ;
-   un bloc pour synthétiser dans le domaine numérique le signal à injecter à partir dudit spectre numérique incomplet ;
-   un convertisseur numérique-analogique pour convertir le signal numérique synthétisé en signal analogique ;
-   des moyens de couplage à ladite ligne permettant d'injecter ledit signal analogique dans ladite ligne ;
-   un convertisseur analogique-numérique pour convertir l'écho correspondant au signal injecté ;
-   des moyens de traitement pour :

    •   effectuer des mesures échantillonnées dudit écho et mémorisant les échantillons ;
    •   calculer le spectre numérique ($Y_{cancel}$) dudit écho ;
    •   estimer le spectre numérique ($\hat{Y}_{full}$) de l'écho du signal analogique complet si celui-ci avait été injecté, la k$^{\text{ième}}$ composante ($\hat{Y}_{fullk}$) du spectre numérique complet estimé étant égale à la k$^{\text{ième}}$ composante ($Y_{cancelk}$) du spectre numérique de l'écho reçu multiplié par le rapport ($\xi_k$) entre la k$^{\text{ième}}$ composante ($X_{fullk}$) du spectre numérique du signal d'injection complet sur la k$^{\text{ième}}$ composante ($X_{cancelk}$) du spectre numérique incomplet : et
    •   obtenir le réflectogramme de ladite ligne à partir du spectre numérique complet estimé ($\hat{Y}_{full}$).

D'autres caractéristiques et avantages de l'invention apparaîtront à l'aide de la description qui suit, faite en regard de dessins annexés qui représentent :

-   La figure 1, un exemple de dispositif de réflectométrie couplé à un câble, apte à mettre en oeuvre le procédé selon l'invention ;

- La figure 2, les étapes possibles d'un procédé selon l'invention ;
- La figure 3, un exemple de spectre numérique d'un signal d'injection plein et de spectre d'un signal atténué ;
- Les figures 4a et 4b, des réflectogrammes obtenus respectivement sans et avec la mise en oeuvre du procédé selon l'invention.

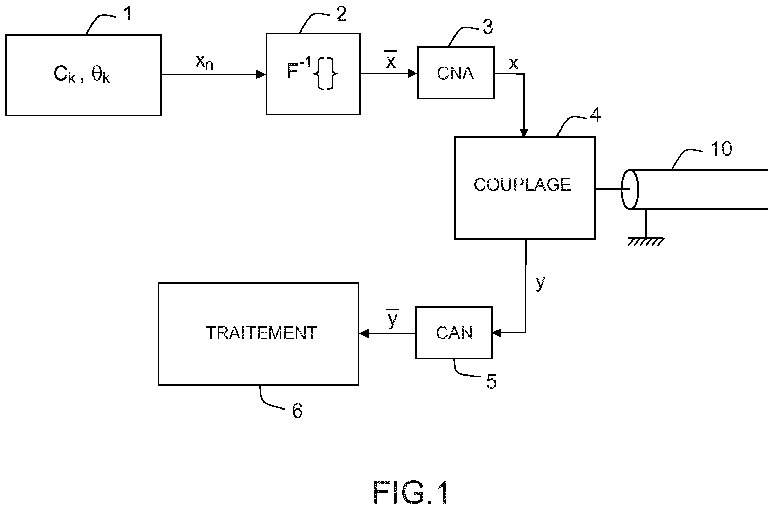

La figure 1 présente un exemple d'architecture d'un dispositif de réflectométrie multiporteuse MCTDR composé de différents blocs, apte à mettre en oeuvre l'invention.

Dans cet exemple de réalisation le dispositif comporte un premier bloc 1 pour le paramétrage du signal de test x à injecter. Ce signal analogique est obtenu à partir d'un signal échantillonné paramétré dans ce premier bloc. Ce signal étant paramétré sur N échantillons, un échantillon $x_n$ s'exprime selon la relation suivante :

$$x_n = 2 \sum_{k=0}^{N/2-1} c_k \cos\left(2\pi \frac{nk}{N} + \theta_k\right) \qquad (1)$$

Les échantillons $x_n$ sont échantillonnés selon une période d'échantillonnage Te.

Le bloc de paramétrage est suivi par un bloc 2 qui synthétise le signal de test par transformée de Fourier inverse. En sortie de ce bloc 2, on obtient donc le signal de test numérisé $\bar{x}$. Un convertisseur numérique-analogique 3 convertit ce signal dans le domaine analogique pour obtenir le signal à injecter x.

Ce signal MCTDR, x, n'est autre qu'une somme de sinusoïdes pondérées par un jeu de coefficients $c_k$, où $\theta_k$ est la phase de la $k^{ième}$ sinusoïde.

Le signal x est injecté dans le câble 10 à diagnostiquer via des moyens de couplage 4. Ces mêmes moyens permettent de réceptionner le signal réfléchi y. Ce dernier est converti numériquement par un convertisseur analogique-numérique 5, puis il est analysé par des moyens de traitement 6 pour en déduire la réponse impulsionnelle estimée $\hat{h}$ du câble 10.

On peut montrer que le module du spectre analogique X(f) du signal MCTDR injecté est donné par la relation suivante (2), f étant la variable fréquence :

$$\left|X(f)\right| = f_{\max} \sum_{k=0}^{N/2-1} c_k \sum_{n=-\infty}^{+\infty} \left[\delta\left(f - f_{\max}\left(\frac{k}{N} + n\right)\right) + \delta\left(f + f_{\max}\left(\frac{k}{N} - n\right)\right)\right] \qquad (2)$$

$f_{max}$ étant la fréquence maximum composant le signal MCTDR ;
$\delta$ étant la fonction de Dirac.

Cette relation montre que lorsqu'on annule ou que l'on atténue un coefficient $c_k$, on impacte en particulier

$$f = \frac{kf_{\max}}{N} \, .$$

A titre d'exemple, si N = 256 et $f_{max}$ = 200 MHz, et si on souhaite annuler le signal MCTDR dans la bande 10 à 20 MHz :

- On calcule $k_1 = 256 \times \frac{10}{200} \approx 13$ et $k_2 = 256 \times \frac{20}{200} \approx 26$
- Et on paramètre $c_{13} = c_{14} = ... = c_{26} = 0$.

Le signal MCTDR est donc fortement dénaturé par l'annulation ou l'atténuation très forte de ces coefficients, ce qui introduit des biais dans l'analyse de la réponse impulsionnelle et donc dans le diagnostic du câble.

L'invention a notamment pour but de surmonter ce problème. Pour cela, l'invention utilise avantageusement le fait que la $k^{ième}$ composante, $X_k$, du spectre numérique du signal MCTDR injecté, peut s'écrire selon la relation (3) suivante :

$$X_k = c_k e^{j\left(\theta_k - k\pi\frac{P-1}{NP}\right)} \frac{\sin\left(\dfrac{k\pi}{N}\right)}{\sin\left(\dfrac{k\pi}{NP}\right)} \qquad\qquad (3)$$

$P$ représente le rapport entre la fréquence d'échantillonnage 1/Te et la fréquence maximum $f_{max}$ du signal MCTDR. Pour respecter la condition de Shannon, il faut choisir $P \geq 2$, mais un sur-échantillonnage peut être réalisé en prenant par exemple $P$ égal à 10 ou à 20.

Dans la suite de la description, on notera $X_{full}$ le spectre numérique pour lequel on n'atténue aucun des coefficients $c_k$ et $X_{cancel}$ le spectre que l'on doit utiliser pour respecter les contraintes CEM imposées dans l'application cible. $X_{cancel}$ correspond au cas où des coefficients $c_k$ sont atténués. Dans l'invention, les coefficients $c_k$ ne sont pas annulés mais seulement très atténués. Ils peuvent avoir une valeur très faible, par exemple de l'ordre de 0,01 mais restent non nuls. Un coefficient $c_k$ non atténué est égal à 1.

En utilisant les notations précédentes, on peut également écrire :

$X_{full} = F\{x_{full}\}$ et $X_{cancel} = F\{x_{cancel}\}$, $F\{\ \}$ étant comme indiqué précédemment la Transformée de Fourier.

$x_{full}$ et $x_{cancel}$ sont respectivement les signaux avec tous les coefficients $c_k$ non atténués et avec des coefficients $c_k$ atténués.

On notera également $y_{full}$ et $y_{cancel}$ les échos respectifs des signaux $x_{full}$ et $x_{cancel}$.

On notera de même :

$$Y_{full} = F\{y_{full}\}$$

et

$$Y_{cancel} = F\{y_{cancel}\}.$$

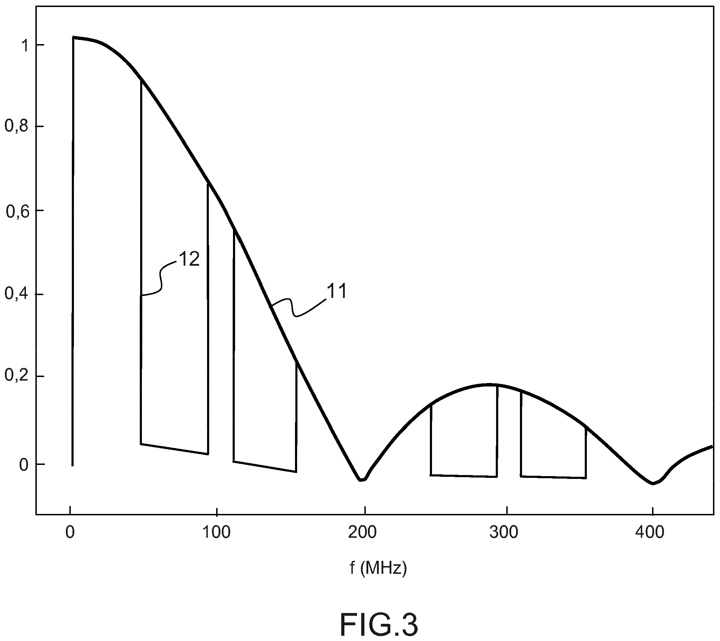

Un exemple de spectre numérique $X_{full}$ et un exemple de spectre numérique $X_{cancel}$ sont illustrés en figure 3, respectivement par une première courbe 11 et une deuxième courbe 12.

L'invention permet d'obtenir une estimation la plus proche possible de l'écho $y_{full}$ correspondant au signal MCDTR complet $x_{full}$, sans atténuations, à partir du signal d'écho $y_{cancel}$ obtenu à partir du signal MCTDR incomplet $x_{cancel}$.

$Y_{full}$ et $Y_{cancel}$ vérifient l'ensemble des deux relations (4) suivantes :

$$\begin{cases} Y_{full} = X_{full} \cdot H \\ Y_{cancel} = X_{cancel} \cdot H \end{cases} \qquad\qquad (4)$$

où $H = F\{h\}$, $h$ étant la réponse impulsionnelle du câble.

Afin d'obtenir $H$ et donc $h = F^{-1}\{H\}$ :

- ayant injecté le signal $x_{cancel}$ ;
- mesuré l'écho correspondant $y_{cancel}$ ;
- puis calculé $X_{full} = F\{x_{full}\}$, $X_{cancel} = F\{x_{cancel}\}$, et $Y_{cancel} = F\{y_{cancel}\}$

une solution pourrait être d'estimer $Y_{full}$ selon le calcul suivant : $\hat{Y}_{full} = \dfrac{X_{full}}{X_{cancel}} \times Y_{cancel}$ , $\hat{Y}_{full}$ étant la valeur estimée de $Y_{full}$.

Malheureusement, cette solution pose des problèmes de mise en oeuvre car $X_{cancel}$ peut s'annuler en raison

notamment des coefficients $c_k$ mais s'annule aussi systématiquement à tous les N points à cause du terme $\sin\left(\dfrac{k\pi}{N}\right)$.

Si on note :

- $(c_k; \theta_k)$ les couples coefficients et phases associés à $X_{\text{cancel}}$ ;
- $(1; \varphi_k)$ les couples coefficient et phases associés à $X_{\text{full}}$, les coefficients $c_k$ étant tous égaux à 1 pour $x_{\text{full}}$.

En utilisant avantageusement la relation (3) décrite précédemment, la k$^{\text{ième}}$ composante de $X_{\text{full}}$ et $X_{\text{cancel}}$ peuvent être liés selon la relation suivante, k variant de 0 à NP-1 :

$$\frac{X_{\text{full}_k}}{X_{\text{cancel}_k}} = \frac{e^{j\left(\varphi_k - k\pi\frac{P-1}{NP}\right)}}{c_k e^{j\left(\theta_k - k\pi\frac{P-1}{NP}\right)}} = \frac{e^{j(\varphi_k - \theta_k)}}{c_k} = \xi_k \qquad (5)$$

$\xi_k$, qui représente le rapport entre la k$^{\text{ième}}$ composante du spectre numérique $X_{\text{full}}$ et la k$^{\text{ième}}$ composante du spectre numérique $X_{\text{cancel}}$, est facilement calculable à partir des valeurs des couples $(c_k; \theta_k)$ et $(1; \varphi_k)$ qui sont connus.

Le signal injecté étant calculé sur N points, pour obtenir les NP valeurs de $\xi_k$, on calcule le signal sur N points et on reprend P fois les N valeurs calculées obtenant ainsi P périodes de N points, donnant un caractère périodique à l'ensemble des NP rapports $\xi_k$. Dans le domaine temporel, cela revient à maintenir l'injection de chacun des N échantillons P fois, ce qui est précisément à l'origine du suréchantillonnage.

Ainsi, la k$^{\text{ième}}$ composante de $\hat{Y}_{\text{full}}$ est :

$$\hat{Y}_{fullk} = \xi_k \cdot Y_{cancelk} \qquad (6)$$

N étant le nombre de points ou d'échantillons et P étant le facteur de sur-échantillonnage, au minimum P = 2, en pratique P peut avoir une valeur égale par exemple à 10 ou à 20. On décrira par la suite comment peut être réalisé le sur-échantillonnage.

La seule condition d'existence pour $\hat{Y}_{fullk}$ est que $c_k$ soit non nul, quel que soit le rang $k$.

Ayant décrit le principe de l'invention, on peut maintenant décrire un exemple de mise en oeuvre.

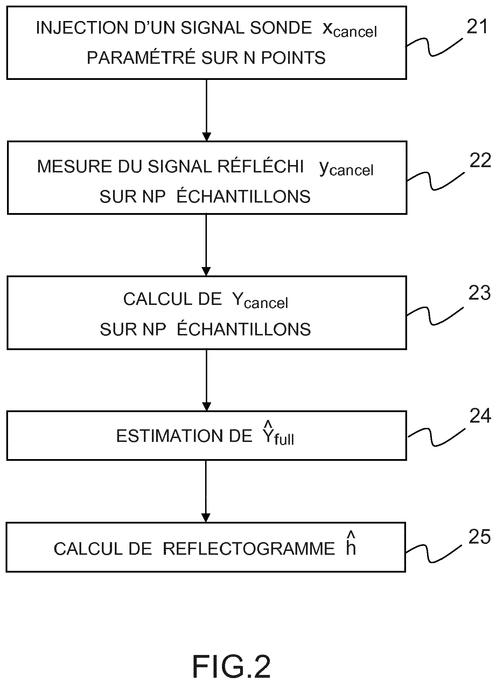

La figure 2 illustre donc des étapes possibles pour la mise en oeuvre du procédé selon l'invention. Le procédé peut être appliqué par un dispositif tel que décrit par la figure 1.

Dans une première étape 21, on injecte un signal de sonde $x_{cancel}$ paramétré sur N points. Dans une étape préliminaire, en fonction des conditions ou des contraintes à respecter, on calcule les coefficients $c_k$ qui doivent être atténués, en attribuant par exemple la valeur 0,1 à ces coefficients atténués, et 1 aux autres coefficients. Cette première étape 21 peut être réalisée au moyen des composants 1, 2, 3 du dispositif de la figure 1 permettant d'obtenir le signal MCTDR incomplet $x_{cancel}$ et des moyens de couplage 4. Le paramétrage des coefficients $c_k$, et des phases $\theta_k$ dans le bloc 1 peut être réalisé au moyen d'une interface adaptée, bien connue par ailleurs.

Pour des raisons pratiques, notamment au niveau des moyens de couplage 4, le signal injecté $x_{cancel}$ ne peut pas avoir de composante continue. Il faut donc $c_0 = 0$.

Pour éviter des problèmes de division par 0, on impose donc par exemple la condition suivante :

$$\forall p \in [0, P-1] \quad \xi_{p \cdot N} = 0 \qquad (7)$$

La relation (7) signifie notamment que les composantes fréquentielles correspondant à k = 0, k = N, k = 2N, k = 3N, ... k = (P-1)N de $\xi_k$ sont nulles. C'est notamment le cas dès lors que l'on paramètre $c_0 = 0$, en raison notamment de la périodicité des échantillons $\xi_k$ (P périodes de N échantillons).

Le signal ayant été injecté dans le câble puis réfléchi, dans une deuxième étape 22, on mesure le signal réfléchi $y_{cancel}$ correspondant au signal $x_{cancel}$ injecté. Cette mesure est effectuée sur NP échantillons.

En pratique les NP mesures sont par exemple effectuées en appliquant N premiers échantillonnage à la fréquence d'échantillonnage 1/Te décrite précédemment et en renouvelant P fois ces N mesures d'échantillonage, les N mesures de chaque série étant déphasées par rapport aux N mesures de la série précédente. De cette façon, on échantillonne toujours l'écho $y_{cancel}$ à une fréquence d'horloge égale à 1/Te mais les P séries de mesures déphasées permettent en fait d'obtenir une fréquence d'échantillonnage équivalente égale à 1/(P.Te). Un exemple de sur-échantillonnage pouvant être appliqué est notamment décrit dans le document WO 2009/087045 A1. Dans l'exemple de dispositif de la figure 1, cette deuxième étape 22 peut être mise en oeuvre par les moyens de couplage 4, le convertisseur analogique-numérique 5 et par les moyens de traitement qui reçoivent l'écho $y_{cancel}$ numérisé.

Pour effectuer les mesures sur-échantillonnées telles que décrites ci-dessus, le dispositif comporte par exemple une horloge générant des signaux à la fréquence de 1/Te et un compteur. Il est également possible d'utiliser des composants à verrouillage de phase du type PLL ou DLL. Les signaux d'horloge émis à 1/Te commandent l'échantillonnage de l'écho $y_{cancel}$ numérisé en sortie du convertisseur 5, le signal $y_{cancel}$ étant échantillonné à chaque signal d'horloge émis. Le compteur compte les coups d'horloge. Lorsque N coups d'horloge ont été comptés, le signal d'horloge est déphasé avant d'engager une série suivante de N mesures échantillonnées et ainsi de suite.

L'application d'un tel sur-échantillonnage, réalisant NP mesures d'échantillons, permet avantageusement d'améliorer l'estimation $\hat{Y}_{full}$.

Dans une étape suivante 23, on calcule $Y_{cancel} = F\{y_{cancel}\}$, à partir des NP échantillons de mesures échantillonnées de $y_{cancel}$, ce calcul étant effectué par les moyens de traitement 6. La transformée de Fourrier utilisée est en fait une transformée de Fourier discrète.

Dans une étape suivante 24 étape, on estime le spectre numérique complet $Y_{full}$ sur NP points à l'aide des rapports $\xi_k$ selon les relations (5) et (6). Cette estimation peut également être réalisée par les moyens de traitement 6.

Dans une étape suivante 25, on calcule le réflectogramme du câble qui est la réponse impulsionnelle estimée $\hat{h}$ en fonction de la valeur estimée $\hat{Y}_{full}$ :

$$\hat{h} = F^{-1}\left\{X_{full}^* \hat{Y}_{full}\right\} \qquad (8)$$

Le produit simple $X_{full}^* \hat{Y}_{full}$ dans le domaine fréquentiel représente en fait une corrélation entre $x_{full}$ et $\hat{y}_{full}$ dans le domaine temporel.

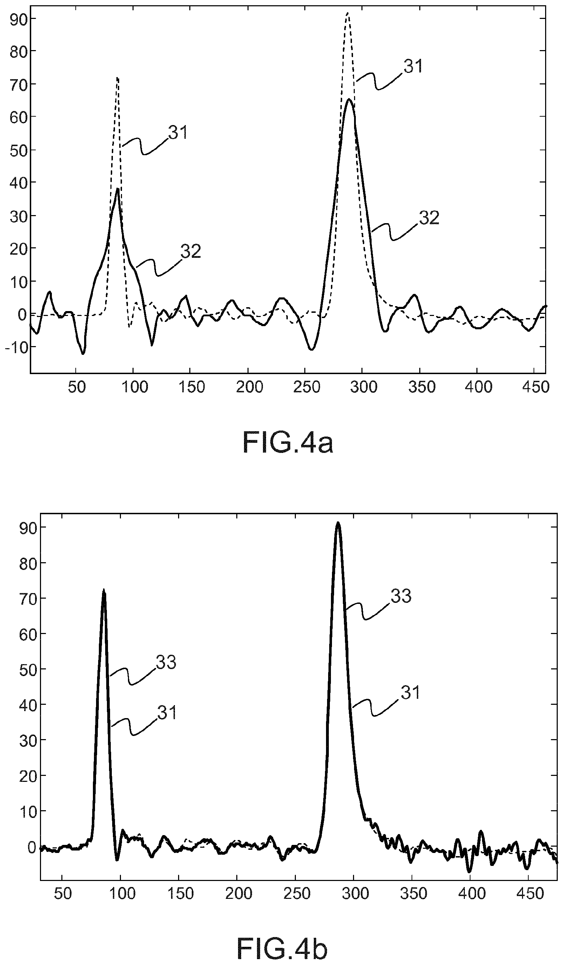

Les figures 4a et 4b représentent les réponses impulsionnelles estimées $\hat{h}$ obtenues respectivement sans et avec la mise en oeuvre du procédé selon l'invention. Il s'agit d'un exemple d'application dans lequel on souhaite diagnostiquer un câble de type paire torsadée de longueur 10 mètres en évitant la bande 48 MHz à 92 MHz qui a été atténuée de 90% (c'est-à-dire que les coefficients $c_k$, correspondant dans cette bande ont été paramétrés à 0,1) et où la fréquence maximale du signal MCTDR était de 200 MHz. Pour ces deux figures :

- L'axe des abscisses représentent les échantillons de 0 à NP-1, un zoom ayant été effectué pour se focaliser sur la partie intéressante du réflectogramme. Il est possibles de convertir cet axe en distance en connaissant la vitesse de propagation sur le câble ;
- L'axe des ordonnées représente le coefficient de réflexion et est gradué en unité arbitraire entre -100% et + 100% ;
- Une première courbe 31 représente la réponse impulsionnelle correspondant un signal injecté sans coefficients atténués, c'est-à-dire $F^{-1}\left\{X_{full}^* Y_{full}\right\}$.

Dans la figure 4a, une deuxième courbe 32 représente la réponse impulsionnelle estimée correspondant à un signal injecté avec les coefficients atténués sans compensation. Cette deuxième courbe 32 représente donc le signal $F^{-1}\left\{X_{full}^* Y_{cancel}\right\}$ ;

Dans la figure 4b, une troisième courbe 33 représente la réponse impulsionnelle estimée correspondant à un signal injecté avec les coefficients atténués avec compensation, c'est-à-dire avec mise en oeuvre du procédé selon l'invention.

Cette deuxième courbe 32 représente donc le signal $F^{-1}\left\{X_{full}^* \hat{Y}_{full}\right\}$.

Dans une variante de mise en oeuvre de l'invention, on peut utiliser un signal d'injection qui n'est pas du type MCTDR. En effet, on peut montrer que l'invention peut avantageusement être généralisée par l'utilisation d'un rapport $\xi$ définie par la relation suivante, correspondant à une régularisation de Tikhonov :

$$\xi = \lim_{\varepsilon \to 0} \frac{X_{\text{full}} X_{\text{cancel}}^*}{\left|X_{\text{cancel}}\right|^2 + \varepsilon} \qquad (9)$$

On peut donc appliquer l'invention également à des signaux comme des impulsions de largeur quelconque ou bien des séquences binaires en créneaux par exemple. Dans ce cas, on choisit dans la relation (9) un $\varepsilon$ pour éviter les problèmes de conditionnement. On le choisit arbitrairement bas, et on l'augmente tant que le calcul de division spectrale de $\xi$ ne converge pas. C'est bien le même $\xi$ que celui de la quatrième étape 24 précédente.

**Revendications**

1. Procédé de diagnostic d'au moins une ligne électrique par des mesures de réflectométrie, ladite ligne électrique (10) étant en fonctionnement dans une bande de fréquences donnée, le diagnostic étant effectué par analyse du réflectogramme de ladite ligne, ledit procédé comportant notamment les étapes suivantes :

   - On paramètre le signal à injecter dans ladite ligne (10), un signal d'injection complet ayant un spectre numérique formé de composantes pondérées par un jeu de coefficients, dans une étape préliminaire on atténue les coefficients des composantes comprises dans ladite bande de fréquence conduisant à l'obtention un spectre numérique incomplet ;
   - Dans une étape suivante (21) on injecte dans la ligne électrique (10) le signal analogique constitué à partir dudit spectre numérique incomplet ;
   - Dans une étape suivante (22) on récupère l'écho correspondant audit signal injecté par échantillonnage de mesures dudit écho ;
   - Dans une étape suivante (23), on calcule le spectre numérique ($Y_{cancel}$) dudit écho ;

   le procédé étant **caractérisé en ce que**

   - Dans une étape suivante (24) on estime le spectre numérique ($\hat{Y}_{full}$) de l'écho du signal analogique complet si celui-ci avait été injecté, la k$^{\text{ième}}$ composante ($\hat{Y}_{fullk}$) du spectre numérique complet estimé étant égale à la k$^{\text{ième}}$ composante ($Y_{cancelk}$) du spectre numérique de l'écho reçu multiplié par le rapport ($\xi_k$) entre la k$^{\text{ième}}$ composante ($X_{fullk}$) du spectre numérique du signal d'injection complet sur la k$^{\text{ième}}$ composante ($X_{cancelk}$) du spectre numérique incomplet ;
   - Dans une étape suivante (25), on obtient la mesure du réflectogramme de ladite ligne à partir du spectre numérique complet estimé ($\hat{Y}_{full}$).

2. Procédé selon la revendication 1, **caractérisé en ce que** le signal injecté étant calculé sur N points, l'écho est échantillonné sur NP points de mesure, le spectre numérique ($Y_{cancel}$) de l'écho étant calculé sur lesdits NP points échantillonnés, P étant strictement supérieur à 2.

3. Procédé selon la revendication 2, **caractérisé en ce que** P est supérieur ou égal à 10.

4. Procédé selon l'une quelconque des revendications 2 ou 3, **caractérisé en ce que** les rapports ($\xi_k$) sont calculés sur N points, les N rapports calculé étant repris P fois.

5. Procédé selon l'une quelconque des revendications précédentes, **caractérisé en ce que** le signal injecté est un signal du type MCTDR.

6. Procédé selon l'une quelconque des revendications précédentes, **caractérisé en ce que** le signal injecté n'étant pas du type MCTDR, ledit rapport est défini selon la relation suivante :

$$\xi = \lim_{\varepsilon \to 0} \frac{X_{\text{full}} X_{\text{cancel}}^{*}}{\left| X_{\text{cancel}} \right|^{2} + \varepsilon}$$

$X_{full}$ et $X_{cancel}$ étant respectivement le spectre numérique du signal d'injection complet et le spectre numérique du signal injecté.

7. Dispositif de réflectométrie, apte à être utilisé pour le diagnostic d'une ligne en fonctionnement dans une bande de fréquences donnée, comportant au moins :

   - un bloc de paramétrage (1) pour paramétrer le signal à injecter dans ladite ligne (10), un signal d'injection complet ayant un spectre numérique formé de composantes pondérées par un jeu de coefficients, les coefficients des composantes comprises dans ladite bande de fréquence étant atténués pour obtenir un spectre numérique incomplet ;
   - un bloc (2) pour synthétiser dans le domaine numérique le signal à injecter à partir dudit spectre numérique incomplet ;

- un convertisseur numérique-analogique (3) pour convertir le signal

numérique synthétisé en signal analogique ;

- des moyens de couplage (4) à ladite ligne (10) permettant d'injecter ledit signal analogique dans ladite ligne ;
- un convertisseur analogique-numérique (5) pour convertir l'écho correspondant au signal injecté ;
- des moyens de traitement (6) pour :

• effectuer des mesures échantillonnées dudit écho et mémorisant les échantillons ;
• calculer le spectre numérique ($Y_{cancel}$) dudit écho :
**caractérisé en ce que** les moyens de traitement sont de plus configurés pour
• estimer le spectre numérique ($\hat{Y}_{full}$) de l'écho du signal analogique complet si celui-ci avait été injecté, la k$^{ième}$ composante ($\hat{Y}_{fullk}$) du spectre numérique complet estimé étant égale à la k$^{ième}$ composante ($Y_{cancelk}$) du spectre numérique de l'écho reçu multiplié par le rapport ($\xi_k$) entre la k$^{ième}$ composante ($X_{fullk}$) du spectre numérique du signal d'injection complet sur la k$^{ième}$ composante ($X_{cancelk}$) du spectre numérique incomplet : et
• obtenir le réflectogramme de ladite ligne à partir du spectre numérique complet estimé ($\hat{Y}_{full}$).

**8.** Dispositif selon la revendication 7, **caractérisé en ce que** le signal injecté étant calculé sur N points, l'écho est échantillonné sur NP points de mesure, le spectre numérique ($Y_{cancel}$) de l'écho étant calculé sur lesdits NP points échantillonnés, P étant strictement supérieur à 2.

**9.** Dispositif selon la revendication 8, **caractérisé en ce que** P est supérieur ou égal à 10.

**10.** Dispositif selon l'une quelconque des revendications 8 ou 9, **caractérisé en ce que** les rapports ($\xi_k$) sont calculés sur N points, les N rapports calculés étant repris P fois.

**11.** Dispositif selon l'une quelconque des revendications 8 à 10, **caractérisé en ce que** le signal injecté est un signal du type MCTDR.

**12.** Dispositif selon l'une quelconque des revendications 8 à 10, **caractérisé en ce que** le signal injecté n'étant pas du type MCTDR, ledit rapport est défini selon la relation suivante :

$$\xi = \lim_{\varepsilon \to 0} \frac{X_{\text{full}} X_{\text{cancel}}^{*}}{\left| X_{\text{cancel}} \right|^{2} + \varepsilon}$$

$X_{full}$ et $X_{cancel}$ étant respectivement le spectre numérique du signal d'injection complet et le spectre numérique du signal injecté.

**Patentansprüche**

**1.** Diagnoseverfahren für mindestens eine elektrische Leitung anhand von Reflektometriemessungen, wobei die elektrische Leitung (10) in einem gegebenen Frequenzband arbeitet, wobei die Diagnose durch Analyse des Reflektogramms der Leitung erfolgt, wobei das Verfahren insbesondere folgende Schritte beinhaltet:

- Parametrieren des in die Leitung (10) einzuspeisenden Signals, wobei ein komplettes Einspeisungssignal ein digitales Spektrum besitzt, welches aus Komponenten besteht, welche durch einen Satz von Faktoren gewichtet sind, wobei die Faktoren der Komponenten, welche in dem Frequenzband beinhaltet sind, in einem vorbereitenden Schritt gedämpft werden, was zum Erzielen eines unvollständigen, digitalen Spektrums führt;
- in einem nächsten Schritt (21) erfolgendes Einspeisen des analogen Signals, welches anhand des unvollständigen digitalen Spektrums gebildet wurde, in die elektrische Leitung (10);
- in einem nächsten Schritt (22) erfolgendes Wiedergewinnen des dem eingespeisten Signal entsprechenden Echos durch Abtasten von Messungen des Echos;
- in einem nächsten Schritt (23) erfolgendes Berechnen des digitalen Spektrums ($Y_{cancel}$) des Echos;

wobei das Verfahren **gekennzeichnet ist durch**:

- in einem nächsten Schritt (24) erfolgendes Schätzen des digitalen Spektrums ($\hat{Y}_{full}$) des Echos des vollständigen, analogen Signals, wenn dieses eingespeist worden ist, wobei die k-te Komponente ($\hat{Y}_{fullk}$) des geschätzten vollständigen, digitalen Spektrums gleich der k-ten Komponente ($Y_{cancelk}$) des digitalen Spektrums des empfangenen Echos ist, welches mit dem Verhältnis ($\xi k$) zwischen der k-ten Komponente ($X_{fullk}$) des digitalen Spektrums des vollständigen Einspeisesignals, geteilt **durch** die k-te Komponente ($X_{cancelk}$) des unvollständigen, digitalen Spektrums, multipliziert wird;
- in einem nächsten Schritt (25) erfolgendes Erzielen der Messung des Reflektogramms der Leitung anhand des geschätzten, vollständigen digitalen Spektrums ($\hat{Y}_{full}$).

2. Verfahren nach Anspruch 1, **dadurch gekennzeichnet, dass** da das eingespeiste Signal an N Punkten berechnet wird, das Echo an NP Messpunkten abgetastet wird, wobei das digitale Spektrum ($Y_{cancel}$) des Echos an den NP abgetasteten Punkten berechnet wird, wobei P streng größer als 2 ist.

3. Verfahren nach Anspruch 2, **dadurch gekennzeichnet, dass** P größer oder gleich 10 ist.

4. Verfahren nach einem der Ansprüche 2 oder 3, **dadurch gekennzeichnet, dass** die Verhältnisse ($\xi k$) an N Punkten berechnet werden, wobei die N berechneten Verhältnisse P Mal übernommen werden.

5. Verfahren nach einem der vorhergehenden Ansprüche, **dadurch gekennzeichnet, dass** das eingespeiste Signal ein Signal vom Typ MCTDR ist.

6. Verfahren nach einem der vorhergehenden Ansprüche, **dadurch gekennzeichnet, dass**, da das eingespeiste Signal kein Signal vom Typ MCTDR ist, das Verhältnis entsprechend folgender Beziehung definiert wird:

$$\xi = \lim_{\varepsilon \to 0} \frac{X_{full} X_{cancel}^{*}}{\left| X_{cancel} \right|^{2} + \varepsilon}$$

wobei $X_{full}$ und $X_{cancel}$ jeweils das digitale Spektrum des vollständigen Einspeisesignals und das digitale Spektrum des eingespeisten Signals sind.

7. Reflektometrievorrichtung, welche in der Lage ist, zur Diagnose einer Leitung verwendet zu werden, welche in einem gegebenen Frequenzband arbeitet, welche mindestens Folgendes beinhaltet:

- einen Parametrierblock (1) zum Parametrieren des in die Leitung (10) einzuspeisenden Signals, wobei ein komplettes Einspeisungssignal ein digitales Spektrum besitzt, welches aus Komponenten besteht, welche durch einen Satz von Faktoren gewichtet sind, wobei die Faktoren der Komponenten, welche in dem Frequenzband beinhaltet sind, gedämpft werden, um ein unvollständiges, digitales Spektrum zu erzielen;
- einen Block (2) zum Synthetisieren des einzuspeisenden Signals im digitalen Bereich anhand des unvollständigen, digitalen Spektrums;
- einen digital-analog-Umwandler (3) zum Umwandeln des synthetisierten, digitalen Signals in ein analoges Signal;
- Mittel zum Koppeln (4) mit der Leitung (10), welche es ermöglichen, das analoge Signal in die Leitung einzuspeisen;
- einen analog-digital-Umwandler (5) zum Umwandeln des dem eingespeisten Signal entsprechenden Echos;
- Mittel zur Bearbeitung (6) zum:

  • Bewerkstelligen von Abtast-Messungen des Echos und Speichern der Abtastwerte;
  • Berechnen des digitalen Spektrums ($Y_{cancel}$) des Echos;

**dadurch gekennzeichnet, dass** die Bearbeitungsmittel zudem konfiguriert sind zum:

  • Schätzen des digitalen Spektrums ($\hat{Y}_{full}$) des Echos des vollständigen analogen Signals, wenn dieses eingespeist wurde, wobei die k-te Komponente ($\hat{Y}_{fullk}$) des geschätzten, vollständigen digitalen Spektrums gleich der k-ten Komponente ($Y_{cancelk}$) des digitalen Spektrums des empfangenen Echos ist, welches mit

dem Verhältnis ($\xi k$) zwischen der k-ten Komponente ($X_{fullk}$) des digitalen Spektrums des vollständigen Einspeisesignals, geteilt durch die k-te Komponente ($X_{cancelk}$) des unvollständigen, digitalen Spektrums, multipliziert wird, und

• Erzielen des Reflektogramms der Leitung anhand des geschätzten, vollständigen digitalen Spektrums ($\hat{Y}_{full}$).

8. Vorrichtung nach Anspruch 7, **dadurch gekennzeichnet, dass** das eingespeiste Signal an N Punkten berechnet wird, das Echo an NP Messpunkten abgetastet wird, wobei das digitale Spektrum ($Y_{cancel}$) des Echos an den NP abgetasteten Punkten berechnet wird, wobei P streng größer als 2 ist.

9. Vorrichtung nach Anspruch 8, **dadurch gekennzeichnet, dass** P größer oder gleich 10 ist.

10. Vorrichtung nach einem der Ansprüche 8 oder 9, **dadurch gekennzeichnet, dass** die Verhältnisse ($\xi k$) an N Punkten berechnet werden, wobei die N berechneten Verhältnisse P Mal übernommen werden.

11. Vorrichtung nach einem der Ansprüche 8 bis 10, **dadurch gekennzeichnet, dass** das eingespeiste Signal ein Signal vom Typ MCTDR ist.

12. Vorrichtung nach einem der Ansprüche 8 bis 10, **dadurch gekennzeichnet, dass**, da das eingespeiste Signal kein Signal vom Typ MCTDR ist, das Verhältnis entsprechend folgender Beziehung definiert wird:

$$\xi = \lim_{\varepsilon \to 0} \frac{X_{\text{full}} X_{\text{cancel}}^*}{\left| X_{\text{cancel}} \right|^2 + \varepsilon}$$

wobei $X_{full}$ und $X_{cancel}$ jeweils das digitale Spektrum des vollständigen Einspeisesignals und das digitale Spektrum des eingespeisten Signals sind.

## Claims

1. A method for diagnosing at least one electrical line by reflectometry measurements, said electrical line (10) being in use within a given frequency band, the diagnosis being carried out by analysis of the reflectogram of said line, said method comprising in particular the following steps:

   - configuring the signal to be injected in said line (10), a complete injection signal having a digital spectrum formed from components weighted by a set of coefficients, the coefficients of the components included within said frequency band being attenuated in a preliminary step, resulting in an incomplete digital spectrum being obtained;
   - in a next step, (21) the analog signal composed from said incomplete digital spectrum is injected into the electrical line (10);
   - in a next step, (22) the echo corresponding to said injected signal is recovered by sampling measurements of said echo;
   - in a next step, (23) the digital spectrum ($Y_{cancel}$) of said echo is calculated;

   the method being **characterized in that**

   - in a next step, (24) the digital spectrum ($\hat{Y}_{full}$) of the echo of the complete analog signal if the latter had been injected is estimated, the kth component ($\hat{Y}_{fullk}$) of the estimated complete digital spectrum being equal to the kth component ($Y_{cancelk}$) of the digital spectrum of the echo received multiplied by the ratio ($\xi k$) between the kth component ($X_{fullk}$) of the digital spectrum of the complete injection signal over the kth component ($X_{cancelk}$) of the incomplete digital spectrum;
   - in a next step, (25), the measurement of the reflectogram of said line is obtained based on the estimated complete digital spectrum ($\hat{Y}_{full}$).

2. The method according to claim 1, **characterized in that**, the injected signal being calculated over N points, the echo is sampled over NP measurement points, the digital spectrum ($Y_{cancel}$) of the echo being calculated over said NP sampled points, P being strictly greater than 2.

3. The method according to claim 2, **characterized in that** P is greater than or equal to 10.

4. The method according to any one of claims 2 or 3, **characterized in that** the ratios ($\xi k$) are calculated over N points, the N calculated ratios being used P times.

5. The method according to any one of the preceding claims, **characterized in that** the injected signal is a signal of the MCTDR type.

6. The method according to any one of the preceding claims, **characterized in that** the injected signal not being of the type MCTDR, said ratio is defined according to the following relationship:

$$\xi = \lim_{\varepsilon \to 0} \frac{X_{\text{full}} X_{\text{cancel}}^*}{\left| X_{\text{cancel}} \right|^2 + \varepsilon}$$

$X_{full}$ and $X_{cancel}$ being respectively the digital spectrum of the complete injection signal and the digital spectrum of the injected signal.

7. A reflectometer device, designed to be used for diagnosing a line in use within a given frequency band, comprising at least:

   - a parameterization block (1) for configuring the signal to be injected into said line (10), a complete injection signal having a digital spectrum formed from components weighted by a set of coefficients, the coefficients of the components included within said frequency band being attenuated so as to obtain an incomplete digital spectrum;
   - a block (2) for synthesizing the signal to be injected, in the digital domain, starting from said incomplete digital spectrum;
   - a digital-analog converter (3) converting the synthesized digital signal into an analog signal;
   - means (4) for coupling to said line (10) allowing said analog signal to be injected into said line;
   - an analog-digital converter (5) converting the echo corresponding to the injected signal;
   - processing means (6) for:

     ▪ carrying out sampled measurements of said echo and storing the samples;
     ▪ calculating the digital spectrum ($Y_{cancel}$) of said echo;

   **characterized in that** the processing means are further configured to

     ▪ estimating the digital spectrum ($\hat{Y}_{full}$) of the echo of the complete analog signal if the latter had been injected, the $k^{th}$ component ($\hat{Y}_{fullk}$) of the estimated complete digital spectrum being equal to the $k^{th}$ component ($Y_{cancelk}$) of the digital spectrum of the echo received multiplied by the ratio ($\xi k$) between the $k^{th}$ component ($X_{fullk}$) of the digital spectrum of the complete injection signal over the $k^{th}$ component ($X_{cancelk}$) of the incomplete digital spectrum; and
     ▪ obtaining the reflectogram of said line based on the estimated complete digital spectrum ($\hat{Y}_{full}$).

8. The device as claimed in claim 7, **characterized in that**, the injected signal being calculated over N points, the echo is sampled over NP measurement points, the digital spectrum ($Y_{cancel}$) of the echo being calculated over said NP sampled points, P being strictly greater than 2.

9. The device according to claim 8, **characterized in that** P is greater than or equal to 10.

10. The device according to any one of claims 8 or 9, **characterized in that** the ratios ($\xi k$) are calculated over N points, the N calculated ratios being used P times.

11. The device according to any one of claims 8 to 10, **characterized in that** the injected signal is a signal of the MCTDR type.

**12.** The device according to any one of claims 8 to 10, **characterized in that**, the injected signal not being of the MCTDR type, said ratio is defined according to the following relationship:

$$\xi = \lim_{\varepsilon \to 0} \frac{X_{full} X_{cancel}^*}{\left| X_{cancel} \right|^2 + \varepsilon}$$

$X_{full}$ and $X_{cancel}$ being respectively the digital spectrum of the complete injection signal and the digital spectrum of the injected signal.

FIG.1

$C_k, \theta_k$ — 1

$F^{-1}\{\}$ — 2

CNA — 3

COUPLAGE — 4

CAN — 5

TRAITEMENT — 6

10

$x_n$

$\overline{x}$

$x$

$y$

$\overline{y}$

INJECTION D'UN SIGNAL SONDE $x_{cancel}$
PARAMÉTRÉ SUR N POINTS

21

MESURE DU SIGNAL RÉFLÉCHI $y_{cancel}$
SUR NP ÉCHANTILLONS

22

CALCUL DE $Y_{cancel}$
SUR NP ÉCHANTILLONS

23

ESTIMATION DE $\hat{Y}_{full}$

24

CALCUL DE REFLECTOGRAMME $\hat{h}$

25

FIG.2

FIG.3

EP 3 304 107 B1

FIG.4a

FIG.4b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2931323 A1

- WO 2009087045 A1

**Littérature non-brevet citée dans la description**

- Multicarrier Reflectometry. *IEEE SENSORS JOUR-NAL,* Juin 2006, vol. 6 (3